(19) **Europäisches Patentamt**
**European Patent Office**
**Office européen des brevets**

(11) **EP 2 848 377 B1**

(12) **EUROPEAN PATENT SPECIFICATION**

(45) Date of publication and mention
of the grant of the patent:
**25.09.2019 Bulletin 2019/39**

(21) Application number: **12876374.5**

(22) Date of filing: **11.05.2012**

(51) Int Cl.:
*H01L 21/67* (2006.01)       *H01L 21/683* (2006.01)
*H05K 13/04* (2006.01)       *H05K 13/08* (2006.01)

(86) International application number:
**PCT/JP2012/062101**

(87) International publication number:
**WO 2013/168278 (14.11.2013 Gazette 2013/46)**

(54) **ELECTRONIC-COMPONENT SUPPORTING HEAD, ELECTRONIC-COMPONENT DETECTION METHOD, AND DIE FEEDING APPARATUS**

STÜTZKOPF FÜR ELEKTRONISCHES BAUTEIL, ERKENNUNGSVERFAHREN FÜR ELEKTRONISCHES BAUTEIL UND PRESSFORMZUFÜHRVORRICHTUNG

TÊTE DE SUPPORT DE COMPOSANT ÉLECTRONIQUE, PROCÉDÉ DE DÉTECTION DE COMPOSANT ÉLECTRONIQUE ET APPAREIL D'ALIMENTATION DE FILIÈRE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**18.03.2015 Bulletin 2015/12**

(73) Proprietor: **FUJI Corporation**
**Chiryu**
**Aichi (JP)**

(72) Inventors:
• **SHIMIZU, Toshinori**
**Chiryu,**
**Aichi, (JP)**
• **OHASHI, Hiroyasu**
**Chiryu,**
**Aichi, (JP)**
• **YAMASAKI, Toshihiko**
**Chiryu,**
**Aichi, (JP)**
• **MURAI, Masaki**
**Chiryu,**
**Aichi, (JP)**

(74) Representative: **Grünecker Patent- und Rechtsanwälte**
**PartG mbB**
**Leopoldstraße 4**
**80802 München (DE)**

(56) References cited:
EP-A1- 1 514 651       WO-A1-2009/005058
JP-A- 2003 133 794     JP-A- 2005 044 991
JP-A- 2005 262 351     JP-A- 2007 221 035
JP-A- 2008 210 925     JP-A- 2009 111 155
JP-A- 2009 123 936     JP-A- 2009 130 334
JP-A- 2012 000 692

## Description

Technical Field

The present invention relates to an electronic component holding head which can pick up and hold multiple electronic components at the same time using multiple suction nozzles, an electronic component detection method for detecting whether electronic components are being held by the suction nozzles of the electronic component holding head, and a die supply machine equipped with an electronic component holding head.

Background Art

An electronic component holding head for holding electronic components is equipped with multiple suction nozzles for picking up and holding electronic components, multiple air passages connected to those multiple suction nozzles, and an air suction device for sucking air in those multiple air passages, and is an item which can pick up and hold multiple electronic components at the same time using multiple suction nozzles. With this kind of electronic component holding head, by picking up and holding multiple electronic components at the same time using multiple suction nozzles, it is possible to achieve a reduction in the time required for each work and so on, which is useful. However, there are cases in which the desired picking up and holding of electronic components cannot be performed due to causes such as pickup errors, so it is necessary to check whether electronic components are being held by the suction nozzles. Considering these circumstances, technology for checking whether electronic components are being held by suction nozzles has been developed and examples of this kind of technology are disclosed in the patent literature below.

> Patent Literature 1: Japanese Unexamined Patent Application Publication Number 2003-133794
>
> Patent Literature 2: Japanese Unexamined Patent Application Publication Number 2009-111155
>
> Patent Literature 3: Japanese Unexamined Patent Application Publication Number 2009-130334

Document EP 1 514 651 A1 discloses a negative pressure attraction device equipped with a plurality of pick and place nozzles. Each nozzle has an air passage connected to a vacuum generator. Connected to each air passage is a pick and place confirming sensor. For a specific channel section area a reference flow rate value is set wherein the measured flow rate is compared to the reference flow rate in order to determine the absence or presence of a lifted part.

Summary of Invention

Problem to be Solved by the Invention

In the electronic component holding heads disclosed in the above patent literature, a flow sensor for detecting the flow of air in the air passage is provided, and a judgment is made as to whether an electronic component is being held by a suction nozzle based on the detection value of the flow sensor. Specifically, when air is being sucked inside the air passage, and the value detected by the flow sensor is fairly low, it is judged that an electronic component is being held by the suction nozzle; and when the value detected by the flow sensor is not low, it is judged that an electronic component is not being held by the suction nozzle. This is because after an electronic component has been picked up and held by a suction nozzle, in other words, after the mouth of the suction nozzle has been blocked by the electronic component, air largely stops flowing through the air passage, and the detection value of the flow sensor becomes low; however, if the electronic component is not being held by the suction nozzle, air flows through the air passage and the detection value of the flow sensor does not become low.

However, electronic component holding heads should be able to hold various sizes of electronic components, so there are cases in which multiple types of suction nozzles are attached, in which case the nozzle diameter of those multiple types of suction nozzles are different to each other. Also, when an electronic component is picked up by a suction nozzle, a small amount of air is sucked between the gap between the nozzle mouth and the electronic component, and in this case, the detected air flow differs greatly based on the nozzle diameter of the suction nozzle. Specifically, there are cases in which, for example, the nozzle diameter of a suction nozzle for holding a large electronic component is multiple times the size of the nozzle diameter of a suction nozzle for holding a small electronic component, and in such cases, for the air flow detected by the flow sensor when an electronic component has been picked up by a suction nozzle, the air flow with the large diameter suction nozzle is multiple times the size of the air flow of the small diameter suction nozzle. Due to this, a reasonable quantity of air flows through an air passage connected to a relatively large diameter suction nozzle regardless of whether an electronic component has been picked up by the suction nozzle, and there is a worry that a wrong judgment will be made that an electronic component has not been picked up by the suction nozzle.

The present invention is an item which takes account of such circumstances and relates to a die supply machine, an electronic component detection method, and an electronic component holding head which can correctly judge whether an electronic component is being held by a suction nozzle.

Means for Solving the Problem

This object is solved by the features of claims 1, 3, and 5. Further improvements are laid down in the subclaims.

The electronic component holding head according to claim 1 of this application is equipped with: multiple suction nozzles for picking up and holding electronic components, multiple air passages provided to correspond to the multiple suction nozzles connected to the suction nozzle among the multiple suction nozzles which corresponds to itself, an air suction device connected to the multiple air passages for sucking air inside the multiple air passages, and multiple flow sensors provided to correspond to the multiple air passages for detecting the amount of air flowing inside the item corresponding to itself among the multiple air passages; and is an electronic component holding head which can pick up and hold multiple electronic components at the same time using multiple suction nozzles; and the electronic component holding head is equipped with an electronic component detection device which detects whether an electronic component is being held by a suction nozzle when air is being sucked by the air suction device; and the electronic component detection device has a setting section for setting threshold values for each of the flow sensors based on the nozzle diameter of the suction nozzle connected to the air passage on which each is provided, a judgment section for judging whether the value detected by each of the sensors when air is being sucked by the air suction device exceeds the threshold value set for each of those values in the setting section, and a recognition section for recognizing that an electronic component is not being held on the suction nozzles for which the detection value of the flow sensor was judged to have exceeded the threshold value and for recognizing that an electronic component is being held on the suction nozzles for which the detection value of the flow sensor was judged to be within the threshold value.

Also, with the electronic component holding head according to claim 1, the electronic component detection device has a correction section for correcting the threshold value set in the setting section based on the detection value for each of the multiple flow sensors when air is being sucked by the air suction device under conditions in which holding work is not being performed by the electronic component holding head.

Also, with the electronic component holding head according to claim 2, for the electronic component holding head according to claim 1, the suction nozzles are removably connected to the air passages and the setting section is configured to set threshold values each time the suction nozzle is removed from and attached to the air passage.

Also, the electronic component detection method according to claim 3 is equipped with: multiple suction nozzles for picking up and holding electronic components, multiple air passages provided to correspond to the multiple suction nozzles connected to the suction nozzle among the multiple suction nozzles which corresponds to itself, an air suction device connected to the multiple air passages for sucking air inside the multiple air passages, and multiple flow sensors provided to correspond to the multiple air passages for detecting the amount of air flowing inside the item corresponding to itself among the multiple air passages; and, for an electronic component holding head which can pick up and hold multiple electronic components at the same time using multiple suction nozzles, is an electronic component detection method for detecting whether an electronic component is being held by the suction nozzle when air is being sucked by the air suction device which includes a setting process for setting threshold values for each of the flow sensors based on the nozzle diameter of the suction nozzle connected to the air passage on which each is provided, a judgment process for judging whether the value detected by each of the flow sensors when air is being sucked by the air suction device exceeds the threshold value set for each of those values in the setting process, and a recognition process for recognizing that an electronic component is not being held on the suction nozzles for which the detection value of the flow sensor was judged to have exceeded the threshold value and for recognizing that an electronic component is being held on the suction nozzles for which the detection value of the flow sensor was judged to be within the threshold value.

Also, the electronic component detection method according to claim 3 includes a correction process for correcting the threshold value set in the setting process based on the detection value for each of the multiple flow sensors when air is being sucked by the air suction device under conditions in which holding work is not being performed by the electronic component holding head.

Also, with the electronic component detection method according to claim 4, for the electronic component detection method according to claim 3, the suction nozzles are removably connected to the air passages and the setting process is configured to set threshold values each time the suction nozzle is removed from and attached to the air passage.

The die supply machine according to claim 5 is equipped with the electronic component holding head according to claim 1 or claim 2 and a die body holding device for holding a die body which is a diced wafer, and supplies multiple of those dies with the electronic component holding head picking up and holding multiple dies from the die body at the same time.

Summary of Invention

With the electronic component holding head according to claim 1 and the electronic component detection method according to claim 3, a threshold value is set for each of the multiple flow sensors based on the nozzle diameter of the suction nozzle connected to each air passage on which each sensor is provided, and the judgment as to whether an electronic component is being held by a suction nozzle is made based on that threshold value and the amount of air flow in the air passage. Specifically, a judgment is made as to whether the detection value of the flow sensor when air is being sucked by the air suction device exceeds the threshold value, and when the detection value is judged to exceed the threshold value it is recognized that an electronic component is not being held, and when the detection value is judged to be within the threshold value it is recognized that an electronic component is being held. By this, it is possible to correctly judge whether an electronic component is being held by a suction nozzle regardless of the size of the nozzle diameter of the suction nozzle.

With the electronic component holding head according to claim 1 and the electronic component detection method according to claim 3, the air flow in the air passage when air is being sucked by the air suction device under conditions in which holding work is not being performed by the electronic component holding head is measured, and the threshold value set in the setting section is corrected based on that measurement value. Specifically, for example, for two suction nozzles which are the same type, because the nozzle diameters are the same, the same threshold value is set. However, there are cases in which the air flow for two suction nozzles of the same type differs due to factors such as form variations in the nozzle diameter. Also, even for one suction nozzle, the air flow of the suction nozzle can decrease due to factors such as aging or nozzle blockages, and there are cases in which the actual air flow is smaller than the air flow expected based on the nozzle diameter. In these cases, by correcting the threshold value based on the air flow under conditions in which the nozzle mouth of the suction nozzle is open, it is possible to judge whether an electronic component is being held by a suction nozzle while considering factors such as form variation in nozzle diameter and nozzle blockages.

With the electronic component holding head according to claim 2 and the electronic component detection method according to claim 4, the suction nozzles are removably connected to the air passages, and a threshold value is set each time a suction nozzle is removed from and attached to an air passage. Changing of suction nozzles on an electronic component holding head is performed relatively frequently, and with this technology a threshold value is set for every suction nozzle change. By this, it is possible to correctly judge whether an electronic component is being held by a suction nozzle for every suction nozzle change.

The electronic component holding head according to any of claims 1 or 2 above is attached to the die supply machine according to claim 5. By this, it is possible to achieve the same effect as above on the die supply machine according to claim 5.

Brief Description of Drawings

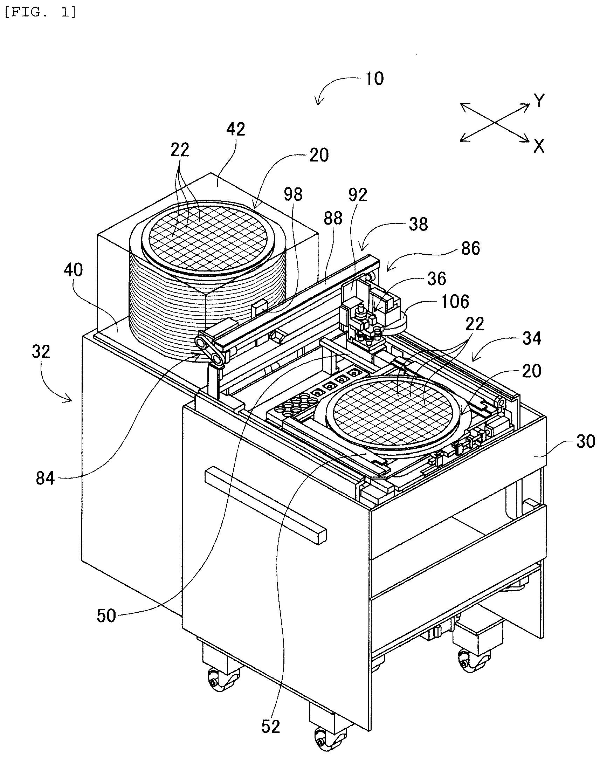

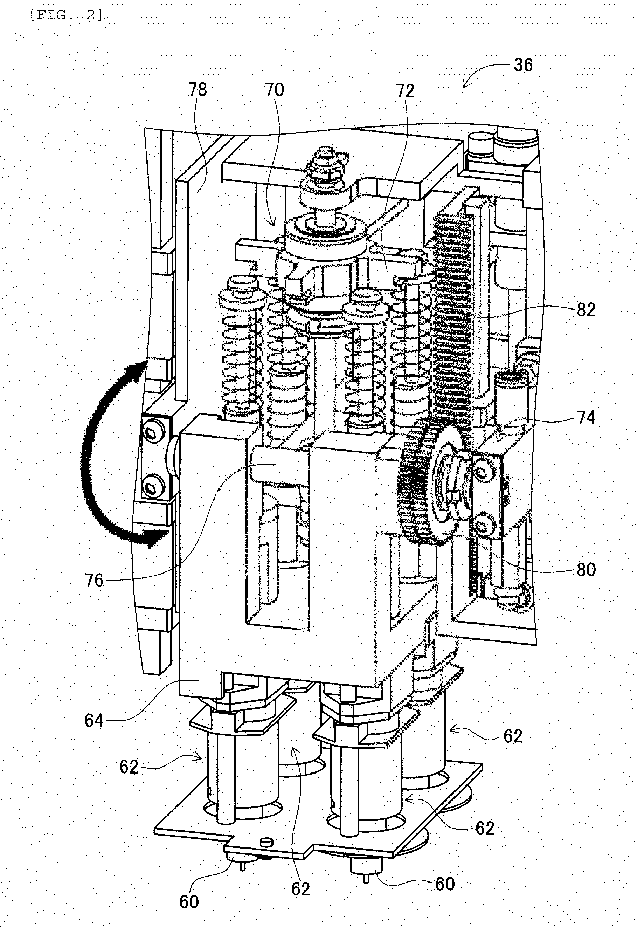

[FIG. 1]
This is a perspective view showing the die supply machine of an embodiment of the present invention.
[FIG. 2]
This is a perspective view showing the pickup head equipped on the die supply machine shown in FIG. 1.
[FIG. 3]
This is a conceptual diagram of the suction nozzles, holding rods, air passages, pump, and flow sensors equipped on the pickup head shown in FIG. 2.
[FIG. 4]
This is a block diagram showing the control device equipped in the die supply machine shown in FIG. 1.

Description of Preferred Embodiments

The following describes in detail referring to the figures, as an embodiment for carrying out the present invention, an example embodiment for the present invention.

Die supply machine configuration

FIG. 1 shows die supply machine 10. Die supply machine 10 is for supplying multiple dies 22 obtained by dicing from die body 20 which is a wafer with a dicing sheet affixed which has been diced. Die body 20 is also referred to as simply a "wafer", and dies 22 are also referred to as "chips".

Die supply machine 10 is equipped with main frame 30, die body storage device 32 for storing multiple die bodies 20 provided together with main frame 30, die body holding device 34 for fixedly holding one die body 20 which is provided on main frame 30, pickup head 36 for picking up dies 22 from die body 20 held by die body holding device 34, and head moving device 38 for moving pickup head 36 to any position above die body 20 held by die body holding device 34. For the descriptions below, the direction in which main frame 30 and die body storage device 32 are lined up is the X direction, and the direction horizontally perpendicular to that direction is the Y direction.

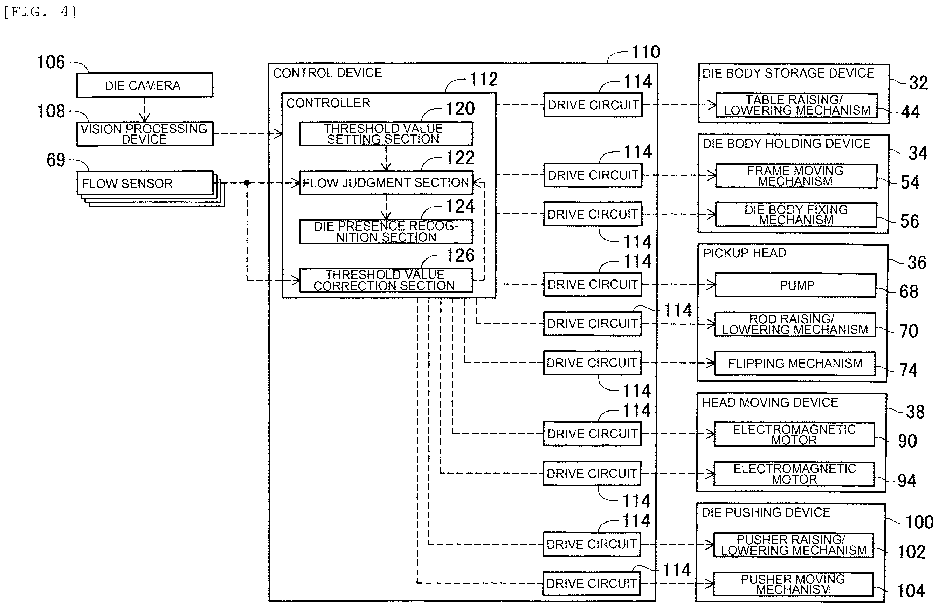

Die body storage device 32 has raising/lowering table 40, rack 42 provided on raising/lowering table 40, and table raising/lowering mechanism (refer to FIG. 4) 44 for raising and lowering in the up/down direction raising/lowering table 40. Inside rack 42, multiple die bodies 20 are stored in a stacked state, and by moving raising/lowering table 40 up and down using table raising/lowering mechanism 44, stacked multiple die bodies 20 are moved up and down. Also, a die body 20 positioned at a specific height can be pulled forward onto die body holding device 34.

Die body holding device 34 has one pair of guide rails (in the figure only one is shown) 50 provided extending in the X direction on main frame 30, holding frame 52 held to be movable in the X direction along the pair of guide rails 50, and frame moving mechanism (refer to FIG. 4) 54 for moving holding frame 52 in the X direction; and die body 20 pulled out from die body storage device 32 is held on holding frame 52 so that the held die body 20 is moved in the X direction by frame moving mechanism 54. Also, die body holding device 34 has die body fixing mechanism (refer to FIG. 4) 56 and die body 20 is fixed on holding frame 52 by die body fixing mechanism 56.

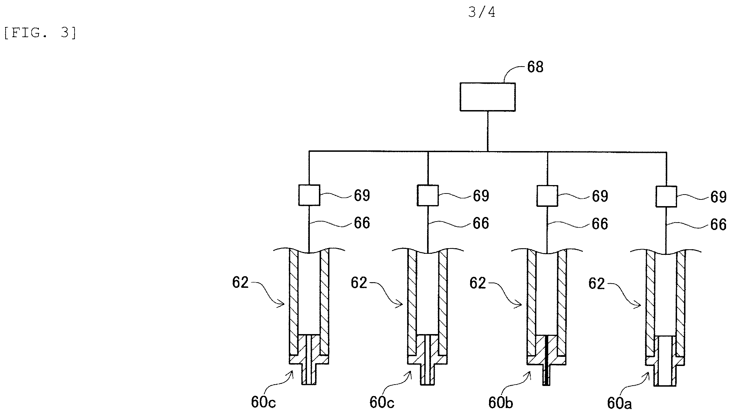

Also, pickup head 36 is an item for picking up dies 22 from die body 20 held by die body holding device 34 and, as shown in FIG. 2, is provided with four holding rods 62 for holding suction nozzles 60 for picking up dies 22 at the lower end. As shown in FIG. 3, air passage 66 connecting to suction nozzle 60 held on each holding rod 62 is formed in each holding rod 62, and each air passage 66 is connected to pump 68 which is the source of the negative pressure. Further, by sucking air through the inside of air passages 66 through the operation of pump 68, dies 22 are picked up and held by suction nozzles 60 using negative pressure. Also, a flow sensor 69 for detecting the amount of air flowing inside each air passage 66 is provided in each air passage 66.

Also, as shown in FIG. 2, holding rods 62 which generally take the form of shafts are held on rod holding body 64 with the axis direction vertical such that they can be moved up and down. Also, the lower end of holding rods 62 extends down from the lower surface of rod holding body 64. Pickup head 36 has rod raising/lowering mechanism 70 and, by the up/down movement of operation block 72 of rod raising/lowering mechanism, is capable of moving the four holding rods 62 up/down at the same time or moving each holding rod 62 up/down individually.

Pickup head 36 also has flipping mechanism 74 for flipping in the up/down direction rod holding body 64; and holding rods 62 being held on rod holding body 64 can be flipped upside down by the operation of flipping mechanism 74. In detail, rod holding body 64 is rotatably held on main section 78 of pickup head 36 by support axis 76 which extends generally in the horizontal direction. Flipping mechanism 74 has pinion 80 fixed to rod holding body 64 coaxially with supporting axis 76 and rack 82 which engages with pinion 80, and, as shown by the arrow in the figure, pinion 80 is rotated by the movement of rack 82 so that rod holding body 64 is flipped around supporting axis 76. By this, holding rods 62 held on rod holding body 64 are flipped and it is possible to position suction nozzles 60 on the upper end of holding rods 62 with the nozzle mouth facing up.

Also, head moving device 38, as shown in FIG. 1, is an XY robot type moving device which is capable of moving pickup head 36 to any position on main frame 30. To describe in detail, head moving device 38 is equipped with X direction slide mechanism 84 for moving pickup head 36 in the X direction, and Y direction slide mechanism 86 for moving pickup head 36 in the Y direction. X direction slide mechanism 84 has X direction slider 88 provided movably in the X direction on main frame 30 and electromagnetic motor (refer to FIG. 4) 90, and X direction slider 88 is capable of being moved to any position in the X direction by electromagnetic motor 90. Also, Y direction slide mechanism 86 has Y direction slider 92 provided movably in the Y direction on the side of X direction slider 88 and electromagnetic motor (refer to FIG. 4) 94, and Y direction slider 92 is capable of being moved to any position in the Y direction by electromagnetic motor 94. Further, by pickup head 36 being attached to Y direction slider 92, pickup head 36 is capable of being moved to any position on main frame 30 by head moving device 38.

Also, clamp 98 for clamping die body 20 is attached to the rear of X direction slider 88 of head moving device 38. Clamp 98 is an item for clamping die body 20 when die body 20 is pulled out from die body storage device 32 to holding frame 52 of die body holding device 34, and by moving X direction slider 88 to which clamp 98 is attached, die body 20 clamped by clamp 98 is capable of being moved in the X direction.

Also, die supply machine 10 is equipped with die pushing device (refer to FIG. 4) 100 which is provided under die body holding device 34. Die pushing device 100 has a pushing tool (omitted from figures) for pushing from below and raising die 22 of die body 20 held by die body holding device 34, pushing tool raising/lowering mechanism (refer to FIG. 4) 102 for raising and lowering the pushing tool, and pushing tool moving mechanism (refer to FIG. 4) 104 for moving the pushing tool to any position under die body 20; and is an item for supporting the pickup of dies 22 by pickup head 36. In detail, the pushing tool is moved below die 22 to be picked up by pickup head 36 and the pushing tool is raised at that position. By this, die 22 is raised and that raised die 22 is picked up by a suction nozzle 60 of pickup head 36.

Also, die supply machine 10 is equipped with die camera 106. Die camera 106 is fixed to Y direction slider 92 facing down, and, by being moved by head moving device 38, is capable of capturing an image of any position on die body 20 held by die body holding device 34. Image data obtained by die camera 106 is processed in image processing device (refer to FIG. 4) 108, and various information can be obtained from the image data.

Further, as shown in FIG. 4, die supply machine 10 is equipped with control device 110. Control device 110 is equipped with controller 112 which consists mainly of a computer equipped with a CPU, ROM, RAM and so on, and multiple drive circuits 114 which correspond respectively to the above table raising/lowering mechanism 44, frame moving mechanism 54, die body fixing mechanism 56, pump 68, rod raising/lowering mechanism 70, flipping mechanism 74, and electromagnetic motors 90 and 94. Also, a drive source for the die body storage device, holding device, and so on is connected to controller 112 via each drive circuit 114, such that the operation of the die body storage device, holding device, and so on can be controlled. Also, image processing device 108 for processing image data obtained by die camera 106 and flow sensors 69 for detecting the amount of air flowing through air passages 66 are connected to controller 112.

Die supply by the die supply machine

With die supply machine 10, by the configuration given above, as well as picking up dies 22 from die body 20, picked up dies 22 can be supplied. Specifically, first, holding frame 52 without a die body 20 loaded is moved to the die storage body device 32 side, in other words, the rear side, by frame moving mechanism 54. Then, multiple stacked die bodies 20 are raised/lowered by table raising/lowering mechanism 44, so that one die body 20 among the multiple die bodies 20 is moved to a specific height.

Next, by X direction slider 88 being moved to the rear by X direction slide mechanism 84, die body 20 moved to a specific height is clamped by clamp 98 attached to X direction slider 88. Then, by X direction slider 88 being moved to the front by X direction slide mechanism 84, die body 20 clamped by clamp 98 is loaded onto holding frame 52. Die body 20 loaded onto holding frame 52 is fixed to holding frame 52 by die body fixing mechanism 56, and holding frame 52 is moved forward by frame moving mechanism 54. By this, die body 20 being fixedly held by holding frame 52 is positioned at a specific work position (in FIG. 1, the position at which die body 20 is shown being held by holding frame 52).

When die body 20 is positioned at the work position, die camera 106 is moved by head moving device 38 above die 22 to be picked up. Then, an image of die 22 is captured by die camera 106 and position information of die 22 is obtained from that image. Here, when four dies 22 are to be picked up by four suction nozzles 60, position information of four dies is obtained.

Continuing, based on the position information of die 22 obtained from the image of die 22, pickup head 36 is moved by head moving device 38 above die 22 to be picked up. Then, one holding rod 62 is lowered by rod raising/lowering mechanism 70. While holding rod 62 is being lowered, air inside air passage 66 is sucked by pump 68, and air is sucked from the nozzle mouth of suction nozzle 60 being held at the lower end of holding rod 62. By this, die 22 is picked up and held by suction nozzle 60 and is picked up from die body 20.

Also, when die 22 is picked up by suction nozzle 60, that die 22 to be picked up is pushed up by the pushing tool of die pushing device 100 such that the pickup of die 22 is supported. And, by performing the above pickup operation of die 22 for each of the four holding rods 62, four dies 22 are picked up and held by four suction nozzles 60 at the same time such that pickup of four dies 22 is completed. Here, with pickup head 36, four holding rods 62 can be raised/lowered at the same time by rod raising/lowering mechanism 70, and it is possible to lower four holding rods 62 at the same time and to pick up four dies 22 at the same time.

When pickup of four dies 22 is complete, pickup head 36 is moved to a specific position on main frame 30 by head moving device 38, and at that position the four holding rods 62 are flipped upside down by flipping mechanism 74. By this, suction nozzle 60 of each holding rod 62 is positioned at the upper end of each holding rod 62, and each die 22 picked up and held by suction nozzle 60 is supplied to that position. Die 22 supplied to that position is held by a mounting head of a panel work machine or the like and used in mounting work to a circuit board.

Detecting whether a die is being held by a suction nozzle

As given above, with die supply machine 10, four dies 22 are picked up and held at the same time by four suction nozzles 60, and four dies 22 can be supplied. However, there are also cases in which the picking and holding of four dies 22 by four suction nozzles 60 cannot be performed due to causes such as pickup errors, so it is necessary to check whether a die 22 is being held by a suction nozzle 60 when supplying dies 22 by pickup head 36. Due to this, with die supply machine 10, whether a die 22 is being held by a suction nozzle 60 is detected based on the amount of air flow in air passage 66 connected to each suction nozzle 60. Below, the method for detecting whether a die 22 is being held by a suction nozzle 60 is described in detail.

When a die 22 is picked up by a suction nozzle 60, as given above, air is sucked through air passage 66 by pump 68. Due to this, before die 22 is picked up by suction nozzle 60, in other words, before the nozzle mouth of suction nozzle 60 is blocked by die 22, air flows through air passage 66, and the detection value of flow sensor 69 provided in air passage 66 is high. Conversely, after die 22 has been picked up by suction nozzle 60, in other words, after the nozzle mouth of suction nozzle 60 has been blocked by die 22, air largely stops flowing through air passage 66, and the detection value of flow sensor 69 is low. In other words, when air is sucked through air passage 66 by pump 68, if the detection value of flow sensor 69 is fairly low, a die 22 is being held by suction nozzle 60, but if the detection value of flow sensor 69 is not low, there is not a die 22 being held on suction nozzle 60.

Here, with die supply machine 10, when the detection value of flow sensor 69 exceeds a specified threshold value, it is recognized that a die 22 is not being held by suction nozzle 60, and when the detection value of flow sensor 69 does not exceed a specified value, it is recognized that a die 22 is being held on suction nozzle 60. However, because the amount of air per unit of time which is sucked from the nozzle mouth of suction nozzle 60, in other words, the flow of air per unit of time flowing through air passage 66 varies greatly depending on the size of the nozzle diameter of suction nozzle 60, a threshold value to judge whether a die 22 is being held on suction nozzle 60 is set based on the size of the nozzle diameter of suction nozzle 60.

In detail, suction nozzles 60 held by holding rods 62 are removably attached to holding rods 62, and for suction nozzles 60, various types are used for which the nozzle diameter varies according to the size of dies 22 to be picked up and held. Specifically, as shown in FIG. 3, with pickup head 36, pickup nozzle 60a with a large nozzle diameter used when picking up and holding large dies 22, suction nozzle 60b with a small nozzle diameter used when picking up and holding small dies 22, and suction nozzles 60c with a nozzle diameter in between those of suction nozzles 60a and 60b are used; and attached respectively to two holding rods 62 is suction nozzle 60c, attached to one holding rod 62 is suction nozzle 60a, and attached to one holding rod 62 is suction nozzle 60b.

As seen in the figures, the nozzle diameter of suction nozzle 60a is multiple times the nozzle diameter of suction nozzle 60b, and the amount of air sucked from suction nozzle 60a is multiple times the amount of air sucked from suction nozzle 60b. In other words, the amount of air sucked from the gap between the nozzle mouth and die 22 when die 22 is being held by suction nozzle 60a is multiple times the amount of air sucked from the gap between the nozzle mouth and die 22 when die 22 is being held by suction nozzle 60b. Due to this, with die supply machine 10, a relatively large threshold value A is set for suction nozzle 60a with a large nozzle diameter, and a relatively small threshold value B (B < A) is set for suction nozzle 60b with a small nozzle diameter. Also, for suction nozzle 60c with an intermediate nozzle diameter, a threshold value C between threshold value A for suction nozzle 60a and threshold value B for suction nozzle 60b (B < C < A) is set. By this, it is possible to correctly judge whether a die 22 is being held by suction nozzle 60 regardless of the size of the nozzle diameter of suction nozzle 60.

The relationship between suction nozzles 60a, b, and c and threshold values A, B, and C is stored in control device 110 using map data, and the type of suction nozzles 60 attached to holding rods 62 is entered into control device 110. By this, the thresholds are automatically set based on the suction nozzle 60 attached to holding rod 62, and the threshold value is set again every time a suction nozzle 60 is removed from and attached to holding rod 62. For the entering of the type of suction nozzle 60 into control device 110, it is acceptable to use entry by an operator or automatic judgment by control device 110.

The process for setting thresholds based on the nozzle diameter of suction nozzles 60 is the setting process, and the process for judging whether the value detected by flow sensor 69 exceeds the threshold set in the setting process is the judgment process. Also, the process for recognizing that a die 22 is not being held by suction nozzle 60 when it is judged that the value detected by flow sensor 69 exceeds the threshold, and for recognizing that a die 22 is being held by suction nozzle 60 when the value detected by flow sensor 69 is within the threshold, is the recognition process. Further, as shown in FIG. 4, threshold setting section 120, flow judgment section 122, and die presence recognition section 124 are provided on controller 112 of control device 110 as the functional sections for performing each process.

Also, with die supply machine 10, calibration is performed with respect to the threshold values set in the setting process. Specifically, for example, because the two suction nozzles 60c attached to two holding rods 62 are the same type, the same threshold value is set. However, between two suction nozzles 60c, there are cases in which the air flow per unit of time is different due to factors such as variations in the form of the nozzle diameter. Also, even for one suction nozzle 60, the air flow of the suction nozzle 60 can decrease due to factors such as aging or nozzle blockages, and there are cases in which the actual air flow is smaller than the air flow expected based on the nozzle diameter.

Considering such circumstances, under conditions in which pickup work is not being performed by pickup head 36, air is sucked through air passage 66 by pump 68 and the amount of air flow while air is being sucked is measured by flow sensor 69. The threshold value is then corrected based on the measured air flow amount. Specifically, for example, taking the measured value for the air flow amount during calibration as LC, when the initial value of the air flow amount is LS, the correction for threshold A is performed according to the following formula.

$$A' = A + K \times (LC - LS)$$

Here, A' is the threshold value after correction, and K is the gain. By correcting threshold values in this way, it is possible to judge whether a die 22 is being held on suction nozzle 60 more accurately based on a threshold value which considers factors such as nozzle diameter form variations and nozzle blockages.

The process for correcting threshold values set during the setting process is the correction process, and, as shown in FIG. 4, threshold value correction section 126 is provided on controller 112 of control device 110 as the functional section for performing that correction process.

It should be noted that in the above embodiment die supply machine 10 is one example of a die supply machine, and die body holding device 34, pickup head 36, and control device 110 which comprise die supply machine 10 are one example respectively of a die body holding device, electronic component holding head, and electronic component detection device. Suction nozzle 60, air passage 66, pump 68, and flow sensor 69 which comprise pickup head 36 are one example respectively of a suction nozzle, air passage, air suction device, and flow sensor. Threshold value setting section 120, flow judgment section 122, die presence recognition section 124, and threshold value correction section 126 which comprise control device 110 are one example respectively of a setting section, judgment section, recognition section, and correction section. Also, die 22 is one example of an electronic component, and the detection method for whether a die 22 is being held by suction nozzle 60 is one example of an electronic component detection method.

Further, the present invention is not limited to the above example embodiment, and various changed or improved methods of embodiment are possible based on the knowledge of someone skilled in the art. Specifically, for example, in the above embodiment, die supply machine 10 equipped with pickup head 36 is used as the electronic component holding head, but various work heads for holding electronic components may be used. Specifically, for example, an electronic component mounter equipped with a mounting head or the like for mounting electronic components on a circuit board may be used as the electronic component holding head of the present invention.

Also, in the above embodiment, the threshold value for judging whether a die 22 is being held by suction nozzle 60 is set in advance based on the size of the nozzle diameter of suction nozzle 60, but it is also acceptable to set the threshold value based on the detected value of flow sensor 69 in a state while die 22 is not being held. In other words, it is also acceptable for threshold value setting section 120 to be configured to set threshold values respectively based on the detected values of multiple flow sensors 69 while air is being sucked by pump 68 under conditions in which pickup work is not being performed by pickup head 36.

Symbol descriptions

10: Die supply machine; 20: Die body; 22: Die; 34: Die body holding device; 36: Pickup head (electronic component holding head); 60: Suction nozzle; 66: Air passage; 68: Pump (air suction device); 69: Flow sensor; 110: Control device (electronic component detection device); 120: Threshold setting section (setting section); 122: Flow judgment section (judgment section); 124: Die presence recognition section (recognition section); 126: Threshold correction section (correction section)

**Claims**

1. An electronic component holding head equipped with: multiple suction nozzles (60) for picking up and holding electronic components, multiple air passages (66) provided to correspond to the multiple suction nozzles (60), an air suction device (68) connected to the multiple air passages (66) for sucking air inside the multiple air passages (66), and multiple flow sensors (69) provided to correspond to the multiple air passages (66) for detecting the amount of air flowing inside the multiple air passages (66); which is an electronic component holding head which can pick up and hold multiple electronic components at the same time using multiple suction nozzles (60); wherein the electronic component holding head is equipped with an electronic component detection device which detects whether an electronic component is being held by a suction nozzle (60) when air is being sucked by the air suction device (68); wherein the electronic component detection device has a setting section (120) for setting threshold values (A, B, C) for each of the flow sensors (69) based on the nozzle diameter of the suction nozzle connected to the air passage (66) on which each is provided, a judgment section (122) for judging whether the value detected by each of the sensors (69) when air is being sucked by the air suction device (68) exceeds the threshold value set for each of those values in the setting section (120), and a recognition section (124) for recognizing that an electronic component is not being held on the suction nozzles (60) for which the detection value of the flow sensor (69) was judged to have exceeded the threshold value and for recognizing that an electronic component is being held on the suction nozzles (60) for which the detection value of the flow sensor (69) was judged to be within a range defined by the threshold value,
   **characterized in that**
   the electronic component detection device has a correction section (126) for correcting the threshold value set in the setting section (120) based on the detection value for each of the multiple flow sensors (69) when air is being sucked by the air suction device (68) under conditions in which holding work is not being performed by the electronic component holding head.

2. The electronic component holding head according to claim 1 wherein the suction nozzles (60) are removably connected to the air passages (66) and the setting section is configured to set threshold values each time the suction nozzle (60) is removed from and attached to the air passage (66).

3. An electronic component detection method equipped with: multiple suction nozzles (60) for picking up and holding electronic components, multiple air passages (66) provided to correspond to the multiple suction nozzles (60), an air suction device (68) connected to the multiple air passages (66) for sucking air inside the multiple air passages (66), and multiple flow sensors (69) provided to correspond to the multiple air passages (66) for detecting the amount of air flowing inside the multiple air passages (66); which, for an electronic component holding head which can pick up and hold multiple electronic components at the same time using multiple suction nozzles, is an electronic component detection method for detecting whether an electronic component is being held by the suction nozzle (60) when air is being sucked by the air suction device (68) which includes a setting process for setting threshold values (A, B, C) for each of the flow sensors (69) based on the nozzle diameter of the suction nozzle (60) connected to the air passage (66) on which each is provided, a judgment process for judging whether the value detected by each of the sensors (69) when air is being sucked by the air suction device (68) exceeds the threshold value set for each of those values in the setting process, and a recognition process for recognizing that an electronic component is not being held on the suction nozzles (60) for which the detection value of the flow sensor (69) was judged to have exceeded the threshold value and for recognizing that an electronic component is being held on the suction nozzles (60) for which the detection value of the flow sensor (69) was judged to be within a range defined by the threshold value,
**characterized in that**
the electronic component detection method includes a correction process for correcting the threshold value set in the setting process based on the detection value for each of the multiple flow sensors (69) when air is being sucked by the air suction device (68) under conditions in which holding work is not being performed by the electronic component holding head.

4. The electronic component detection method according to claim 3 wherein the suction nozzles (60) are removably connected to the air passages (66) and the setting process is configured to set threshold values each time the suction nozzle (60) is removed from and attached to the air passage (66).

5. A die supply machine equipped with the electronic component holding head according to claim 1 or claim 2 and a die body holding device (34) for holding a die body (20) which is a diced wafer, which is adapted for supplying multiple of those dies with the electronic component holding head picking up and holding multiple dies (22) from the die body (20) at the same time.

**Patentansprüche**

1. Elektronikbauteil-Haltekopf, ausgestattet mit: mehreren Saugdüsen (60) zum Aufnehmen und Halten elektronischer Bauteile, mehreren Luftkanälen (66), die entsprechend den mehreren Saugdüsen (60) vorgesehen sind, einer angeschlossenen Luftansaugvorrichtung (68) mit den mehreren Luftkanälen (66) zum Ansaugen von Luft innerhalb der mehreren Luftkanäle (66) und mehreren Strömungssensoren (69), die vorgesehen sind, um den mehreren Luftkanälen (66) zu entsprechen, um die Luftmenge zu erfassen, die innerhalb der mehreren Luftkanäle (66) strömt; der ein Elektronikbauteil-Haltekopf ist, der mehrere Elektronikbauteile gleichzeitig unter Verwendung mehrerer Saugdüsen (60) aufnehmen und halten kann; wobei der Elektronikbauteil-Haltekopf mit einer Elektronikbauteil-Erfassungsvorrichtung ausgestattet ist, die erfasst, ob ein Elektronikbauteil von einer Saugdüse (60) gehalten wird, wenn Luft von der Luftansaugvorrichtung (68) angesaugt wird; wobei die Elektronikbauteil-Erfassungsvorrichtung umfasst: einen Einstellabschnitt (120) zum Einstellen von Schwellenwerten (A, B, C) für jeden der Strömungssensoren (69) basierend auf dem Düsendurchmesser der Saugdüse, die mit dem Luftkanal (66) verbundenen ist, an dem jeder vorgesehen ist, einen Beurteilungsabschnitt (122) zum Beurteilen, ob der von jedem der Sensoren (69) erfasste Wert, wenn Luft von der Luftansaugvorrichtung (68) angesaugt wird, den für jeden dieser Werte in dem Einstellabschnitt (120) eingestellten Schwellenwert überschreitet, und einen Erkennungsabschnitt (124) zum Erkennen, dass ein elektronisches Bauteil nicht an den Saugdüsen (60) gehalten wird, für die beurteilt wurde, dass der Erfassungswert des Durchflusssensors (69) den Schwellenwert überschritten hat, und zum Erkennen, dass ein elektronisches Bauteil an den Saugdüsen (60) gehalten wird, für die der Erfassungswert des Durchflusssensors (69) als innerhalb eines durch den Schwellenwert definierten Bereichs beurteilt wurde,
**dadurch gekennzeichnet, dass**
die Elektronikbauteil-Erfassungsvorrichtung einen Korrekturabschnitt (126) aufweist, um den in dem Einstellabschnitt (120) eingestellten Schwellenwert auf der Grundlage des Erfassungswerts für jeden der zahlreichen Strömungssensoren (69) zu korrigieren, wenn Luft von der Luftansaugvorrichtung (68) unter Bedingungen angesaugt wird, unter denen der Haltekopf keine Haltearbeiten ausführt.

2. Elektronikbauteil-Haltekopf nach Anspruch 1, bei dem die Saugdüsen (60) lösbar mit den Luftkanälen (66) verbunden sind und der Einstellabschnitt so konfiguriert ist, dass er immer dann Schwellenwerte einstellt, wenn die Saugdüse (60) von dem Luftkanal (66) gelöst und an ihm angebracht wird.

3. Elektronikbauteil-Erfassungsverfahren, ausgestattet mit: zahlreichen Saugdüsen (60) zum Aufnehmen und Halten elektronischer Bauteile, zahlreichen Luftkanälen (66), die entsprechend den zahlreichen Saugdüsen (60) vorgesehen sind, eine Luftansaugvorrichtung (68), die mit den zahlreichen Luftkanälen (66) zum Ansaugen von Luft innerhalb der zahlreichen Luftkanäle (66) verbunden ist, und zahlreichen Strömungssensoren (69), die vorgesehen sind, um den zahlreichen Luftkanälen (66) zu entsprechen, um die Luftmenge zu erfassen, die innerhalb der zahlreichen Luftkanäle (66) strömt; das für einen Elektronikbauteil-Haltekopf, der mehrere Elektronikbauteile gleichzeitig unter Verwendung mehrerer Saugdüsen aufnehmen und halten kann, ein Elektronikbauteil-Erfassungsverfahren zum Erfassen ist, ob ein Elektronikbauteil durch die Saugdüse (60) gehalten wird, wenn Luft von der Luftansaugvorrichtung (68) angesaugt wird, das umfasst: einen Einstellvorgang zum Einstellen von Schwellenwerten (A, B, C) für jeden der Strömungssensoren (69) basierend auf dem Düsendurchmesser der Saugdüse, die mit dem Luftkanal (66) verbundenen ist, an dem jeder vorgesehen ist, einen Beurteilungsvorgang zum Beurteilen, ob der von jedem der Sensoren (69) erfasste Wert, wenn Luft von der Luftansaugvorrichtung (68) angesaugt wird, den für jeden dieser Werte in dem Einstellvorgang eingestellten Schwellenwert überschreitet, und einen Erkennungsvorgang zum Erkennen, dass ein elektronisches Bauteil nicht an den Saugdüsen (60) gehalten wird, für die beurteilt wurde, dass der Erfassungswert des Durchflusssensors (69) den Schwellenwert überschritten hat, und zum Erkennen, dass ein elektronisches Bauteil an den Saugdüsen (60) gehalten wird, für die der Erfassungswert des Durchflusssensors (69) als innerhalb eines durch den Schwellenwert definierten Bereichs beurteilt wurde,

**dadurch gekennzeichnet, dass**

das Elektronikbauteil-Erfassungsverfahren einen Korrekturvorgang umfasst, um den in dem Einstellvorgang eingestellten Schwellenwert auf der Grundlage des Erfassungswerts für jeden der zahlreichen Strömungssensoren (69) zu korrigieren, wenn Luft von der Luftansaugvorrichtung (68) unter Bedingungen angesaugt wird, unter denen der Haltekopf keine Haltearbeiten ausführt.

4. Elektronikbauteil-Erfassungsverfahren nach Anspruch 3, bei dem die Saugdüsen (60) lösbar mit den Luftkanälen (66) verbunden sind und der Einstellvorgang so konfiguriert ist, dass er immer dann Schwellenwerte einstellt, wenn die Saugdüse (60) von dem Luftkanal (66) gelöst und an ihm angebracht wird.

5. Chip-Zuführmaschine, die mit dem Elektronikbauteil-Haltekopf nach Anspruch 1 oder 2 und einer Chipkörper-Haltevorrichtung (34) zum Halten eines Chipkörpers (20) ausgestattet ist, bei dem es sich um einen in Würfel geschnittenen Wafer handelt, die dazu eingerichtet ist, mehrere dieser Chips, mit dem Elektronikbauteil-Haltekopf zuzuführen, der mehrere Chips (22) von dem Körper (20) gleichzeitig aufnimmt und hält.

**Revendications**

1. Tête de maintien de composants électroniques équipée : d'une pluralité de buses d'aspiration (60) permettant de saisir et de maintenir des composants électroniques, d'une pluralité de passages d'air (66) disposés de manière à correspondre à la pluralité de buses d'aspiration (60), d'un dispositif d'aspiration d'air (68) connecté à la pluralité de passages d'air (66) pour aspirer l'air à l'intérieur de la pluralité de passages d'air (66), et d'une pluralité de débitmètres (69) disposés de manière à correspondre à la pluralité de passages d'air (66) pour détecter la quantité d'air s'écoulant à l'intérieur de la pluralité de passages d'air (66) ; la tête de maintien de composants électroniques étant capable de saisir et de maintenir une pluralité de composants électroniques simultanément à l'aide de la pluralité de buses d'aspiration (60) ; dans laquelle la tête de maintien de composants électroniques est équipée d'un dispositif de détection de composant électronique qui détecte si un composant électronique est maintenu par une buse d'aspiration (60) lorsque l'air est aspiré par le dispositif d'aspiration d'air (68) ; dans laquelle le dispositif de détection de composant électronique comprend une section de réglage (120) pour définir des valeurs seuils (A, B, C) pour chacun des débitmètres (69) en fonction du diamètre de la buse d'aspiration raccordée au passage d'air (66) respectif correspondant, une section d'évaluation (122) pour évaluer si la valeur détectée par chacun des débitmètres (69) lorsque l'air est aspiré par le dispositif d'aspiration d'air (68) dépasse la valeur seuil définie pour chacune de ces valeurs dans la section de réglage (120), et une section de reconnaissance (124) permettant de reconnaître qu'un composant électronique n'est pas maintenu sur les buses d'aspiration (60) pour lesquelles il a été estimé que la valeur de détection du débitmètre (69) dépasse la valeur seuil et de reconnaître qu'un composant électronique est maintenu sur les buses d'aspiration (60) pour lesquelles il a été estimé que la valeur de détection du débitmètre (69) est comprise dans une plage définie par la valeur seuil,

**caractérisée en ce que**

le dispositif de détection de composant électronique comprend une section de correction (126) permettant de corriger la valeur seuil définie dans la section de réglage (120) en fonction de la valeur de détection pour chacun de la pluralité des débitmètres (69) lorsque l'air est aspiré par le dispositif d'aspiration d'air (68) dans des conditions où la tête de maintien de composants électroniques n'exécute pas la tâche de maintien.

**2.** Tête de maintien de composants électroniques selon la revendication 1, dans laquelle les buses d'aspiration (60) sont raccordées de manière amovible aux passages d'air (66) et la section de réglage est configurée pour définir des valeurs seuils à chaque fois que la buse d'aspiration (60) est séparée du passage d'air (66) et reliée à celui-ci.

**3.** Procédé de détection de composant électronique, équipé : d'une pluralité de buses d'aspiration (60) permettant de saisir et de maintenir des composants électroniques, d'une pluralité de passages d'air (66) disposés de manière à correspondre à la pluralité de buses d'aspiration (60), d'un dispositif d'aspiration d'air (68) connecté à la pluralité de passages d'air (66) pour aspirer l'air à l'intérieur de la pluralité de passages d'air (66), et d'une pluralité de débitmètres (69) disposés de manière à correspondre à la pluralité de passages d'air (66) pour détecter la quantité d'air s'écoulant à l'intérieur de la pluralité de passages d'air (66) ; qui, pour une tête de maintien de composants électroniques capable de saisir et de maintenir une pluralité de composants électroniques simultanément à l'aide de la pluralité de buses d'aspiration, est un procédé de détection de composant électronique permettant de détecter si un composant électronique est maintenu par la buse d'aspiration (60) lorsque l'air est aspiré par le dispositif d'aspiration d'air (68), qui comprend un processus de réglage pour définir des valeurs seuils (A, B, C) pour chacun des débitmètres (69) en fonction du diamètre de la buse d'aspiration (60) raccordée au passage d'air (66) respectif correspondant, un processus d'évaluation permettant d'évaluer si la valeur détectée par chacun des débitmètres (69) lorsque l'air est aspiré par le dispositif d'aspiration d'air (68) dépasse la valeur seuil définie pour chacune de ces valeurs dans le processus de réglage, et un processus de reconnaissance permettant de reconnaître qu'un composant électronique n'est pas maintenu sur les buses d'aspiration (60) pour lesquelles il a été estimé que la valeur de détection du débitmètre (69) dépasse la valeur seuil et de reconnaître qu'un composant électronique est maintenu sur les buses d'aspiration (60) pour lesquelles il a été estimé que la valeur de détection du débitmètre (69) est comprise dans une plage définie par la valeur seuil, **caractérisé en ce que**

le procédé de détection de composant électronique comprend un processus de correction permettant de corriger la valeur seuil définie dans le processus de réglage en fonction de la valeur de détection pour chacun de la pluralité des débitmètres (69) lorsque l'air est aspiré par le dispositif d'aspiration d'air (68) dans des conditions où la tête de maintien de composants électroniques n'exécute pas la tâche de maintien.

**4.** Procédé de détection de composant électronique selon la revendication 3, dans lequel les buses d'aspiration (60) sont raccordées de manière amovible aux passages d'air (66) et le processus de réglage est configuré pour définir des valeurs seuils à chaque fois que la buse d'aspiration (60) est séparée du passage d'air (66) et reliée à celui-ci.

**5.** Machine d'alimentation de dés équipée de la tête de maintien de composants électroniques selon la revendication 1 ou la revendication 2 et d'un dispositif de maintien de corps en dés (34) pour maintenir un corps en dés (20) qui est une tranche découpée en dés, conçue pour alimenter une pluralité de ces dés à l'aide de la tête de maintien de composants électroniques qui saisit et maintient une pluralité de dés (22) depuis le corps en dés (20) simultanément.

[FIG. 1]

[FIG. 2]

[FIG. 3]

EP 2 848 377 B1

[FIG. 4]

**REFERENCES CITED IN THE DESCRIPTION**

**Patent documents cited in the description**

- JP 2003133794 A
- JP 2009111155 A
- JP 2009130334 A
- EP 1514651 A1